# EUROPEAN PATENT SPECIFICATION

(11) **EP 3 831 168 B1**
(45) Date of publication and mention of the grant of the patent: **29.05.2024**
(21) Application number: 19779619.6
(22) Date of filing: 01.08.2019
(51) Int. Cl.: H01J 37/32, H05B 47/00, H05H 1/24

(54) **A METHOD FOR PREPARATION OF SUPPLY PULSES TO GENERATE A GLOW DISCHARGE BETWEEN ELECTRODES ENCLOSED IN A CHAMBER WITH REDUCED GAS PRESSURE AND A CIRCUIT FOR PREPARATION OF SUPPLY PULSES TO GENERATE A GLOW DISCHARGE BETWEEN ELECTRODES ENCLOSED IN A CHAMBER WITH REDUCED GAS PRESSURE**
VERFAHREN ZUR HERSTELLUNG VON VERSORGUNGSIMPULSEN ZUR ERZEUGUNG EINER GLIMMENTLADUNG ZWISCHEN ELEKTRODEN, DIE IN EINER KAMMER MIT REDUZIERTEM GASDRUCK EINGESCHLOSSEN SIND, UND SCHALTUNG ZUR HERSTELLUNG VON VERSORGUNGSIMPULSEN ZUR ERZEUGUNG EINER GLIMMENTLADUNG ZWISCHEN ELEKTRODEN, DIE IN EINER KAMMER MIT REDUZIERTEM GASDRUCK EINGESCHLOSSEN SIND
PROCÉDÉ DE PRÉPARATION D'IMPULSIONS D'ALIMENTATION POUR GÉNÉRER UNE DÉCHARGE LUMINESCENTE ENTRE DES ÉLECTRODES ENFERMÉES DANS UNE CHAMBRE À PRESSION DE GAZ RÉDUITE ET CIRCUIT POUR LA PRÉPARATION D'IMPULSIONS D'ALIMENTATION POUR GÉNÉRER UNE DÉCHARGE LUMINESCENTE ENTRE DES ÉLECTRODES ENFERMÉES DANS UNE CHAMBRE AVEC UNE PRESSION DE GAZ RÉDUITE

(30) Priority: 03.08.2018 PL 42653918
(43) Date of publication of application: 09.06.2021
(73) Proprietor: PLASMA INVESTMENT SP. z o.o., 50-082 Wroclaw (PL)
(72) Inventor: RESZKE, Edward, 54-530 worclaw (PL); YELKIN, Ihar, 50-082 Wroclaw (PL)
(74) Representative: Czarnik, Maciej
(86) International application number: PCT/PL2019/000061
(87) International publication number: WO 2020/027672

(56) References cited:
- US-A- 5 111 115
- US-A- 5 543 690
- US-A1- 2007 080 649

## Description

The subject of the present invention is a method of preparation of power pulses to generate glow discharge between electrodes enclosed in a chamber with reduced gas pressure and a circuit for generation of power pulses to generate a glow discharge between electrodes enclosed in a chamber with reduced gas pressure, in particular applicable to energizing a plasma lamp.

The method of supplying a plasma lamp known from Polish patent application PL421774 A1 is based on the measurement of the magnitude of disturbances appearing in the lamp current searching for disturbances with a frequency above the basic frequency of the lamp supply current and adjusting the current level of power supply to supply power to the lamp within the specified range of adjustments related to the current for which the disturbance magnitudes are the highest. The lamp is powered by AC mains with a constant current component.

A plasma lamp with a power supply is known from Polish Patent application PL227530 A1. A lamp in the form of a glass tube filled with a working gas under reduced pressure, equipped with an electrode system, one of which is a cathode connected to the negative terminal of the power supply, and the other electrode is an anode connected to the positive terminal of the power supply, the power supply supplies the lamp with alternating current, which is characterized by that it contains a lamp power monitoring system comprising: A high pass filter connected to one of the power supply terminals with a limiting frequency higher than the basic frequency of the lamp supplying current to which the amplitude detector is connected measuring the magnitude of the amplitude envelope at the high pass filter output representing the disturbances level and the power supply control system connected between the amplitude detector output and the power supply control input adopted to control the power supply for supplying the power supply to the lamp in, the specified range of 0, 1 relative to ls current, for which the levels of disturbances are the highest.

The high voltage pulse generation system, especially devoted for the cold plasma reactor, is known from the Polish patent description PL222184 B1. The system includes at least one converter module connected to a voltage source, the module having two capacitors, two transformers and one semiconductor switch. The module's input is connected to the first secondary side winding terminal of the first transformer whose second secondary winding terminal is connected simultaneously to the first end of the first capacitor and to the first terminal of the primary winding of the first transformer. The other end of the first capacitor is connected to the first end of the semiconductor switch and to the first terminal of the primary winding of the second transformer. The second terminal of the primary winding of the first transformer is connected to the second end of the semiconductor switch and at the same time to the first end of the second capacitor the other end of which is connected to the second terminal of the primary winding of the second transformer and the second terminal of the secondary winding of the second transformer is the output of the module.

US 5 111 115A discloses a fluorescent lamp starter and controller.

US 5 543 690 A discloses a high voltage ignition circuit for a discharge lamp.

US 2007/080649 A1 discloses a high voltage discharge lamp lighting apparatus.

The invention discloses a method for generating supply pulses for generating a glow discharge between electrodes enclosed in a chamber with reduced gas pressure according to the appended claim 1, a system for generating supply pulses for generating a glow discharge between electrodes enclosed in a chamber with reduced gas pressure according to the appended claim 3 and a system for generating supply pulses for generating a glow discharge between electrodes enclosed in a chamber with reduced gas pressure according to the appended claim 7.

The essence of the invention is a method, according to the invention and defined in claim 1, where the pulses are generated by means of a low power generator, then the power and voltage of those pulses are amplified to the level necessary to ignite and maintain the glow discharge between the electrodes, and moreover their time-shape, amplitude, repetition rate and frequency are chosen appropriately such that the number and intensity of resonant beats in plasma oscillations per unit time correspond to the maximum power of coherent resonant oscillations. Preferably, the power of the pulses is amplified in a transformer- less linear amplifier, whereby the DC voltage component is adjusted and/or corrected by means of an adjustable DC voltage source.

The glow discharge between the electrodes is maintained at a working pressure of humid air in the range from 1 Pa to 10⁴ Pa and at a power density in the discharge in the range from 0.2 to 100 W/dm³.

The method according to claim 1, characterized in that the pulse repetition frequency lies in the frequency range of 125 Hz to below 15 kHz.

The shape of the pulses is selected from the group consisting of rectangular pulses, sinusoidal pulses, sinus absolute value pulses, saw-tooth-shaped pulses and trapezoidal pulses.

The level of DC voltage amplitude is selected such that the average current between the electrodes is in the range from 100 µA to 2A.

The ratio of the mean voltage to the maximum value is less than 2/π.

The essence of a system, according to the invention and defined in claim 3 and 7, consists in that in parallel with the terminals of at least one pair of electrodes constituting the anode and cathode when each pair of electrodes is enclosed in the chamber a high frequency capacitor is connected and at the same time a pulse amplifier is connected to the electrode terminals having its input connected to the source of control signals.

The pulse amplifier is a transformer pulse amplifier which on the input has a pulse transistor amplifier connected to the primary winding of the transformer, and the secondary winding of the transformer is connected via a diode rectifier with a rectifier diode and electrode terminals.

Preferably, transistor is used as a pulse transistor amplifier.

Preferably, the pulse transistor amplifier on the input has a synchronous pulse generator equipped with a high level signal controller and a low level signal controller, wherein the high level signal controller is connected to the gate of the upper transistor of the pulse amplifier connected to the first terminal of the primary winding and at the same time through the second energy return diode with the emitter of the lower transistor of the pulse amplifier, the low level signal controller is connected to the gate of the lower transistor of the pulse amplifier, the collector of which is connected to the second terminal of the transformer primary winding and simultaneously via the first energy return diode with the upper transistor of the pulse amplifier in addition, the collector of the upper transistor of the impulse amplifier and the emitter of the lower transistor of the impulse amplifier are connected to the terminals of the regulated voltage source. Preferably, the pulsed transistor amplifier is an integrated circuit of a bridge amplifier. Preferably, the secondary winding of the transformer is connected with electrode terminals via a rectifier having the form of voltage doubler circuit with rectifier diodes and a capacitor.

Preferably, the pulse amplifier is a transformer-less linear amplifier.

Preferably, the transformer-less linear amplifier is formed from a high voltage transistors cascode with a voltage divider and a current resistor and an operational amplifier the non-inverting input of which the is connected to the adder the inverting input is connected between the emitter of lower transistor and the current divider resistor, while the output of the operational amplifier is connected to the gate of the backplane transistor which's collector is connected to the emitter of the upper cascode transistor, and the upper transistors collector is connected through the first voltage divider resistor in the controller and the second voltage divider resistor in the controller with the second terminal of the resistor divider, the upper transistor gate is connected between the first voltage divider resistor in the controller and the second voltage divider resistor in the controller.

Preferably, the source of the control signals is a signal source with adjustable frequency, pulse width and amplitude, which is connected to a pulse transistor amplifier which is supplied from a low voltage power source.

Preferably, the source of the control signals is an arbitrary waveform generator connected via one input of the adder to the transformer-less linear amplifier wherein a DC voltage source is connected to the second input of the adder whereas the transformer- less linear amplifier is connected to a high voltage power source.

Preferably, the arbitrary waveform generator is a generator of arbitrary periodic waveforms.

An advantage of the method according to the invention is the possibility to select not only one parameter such as plasma current allowing for choosing the wider selection of up to five parameters: frequency, amplitude, average current value, anode current time-shape in glow discharge and the mutual relationship between the alternating and direct current components of anode voltage and current.

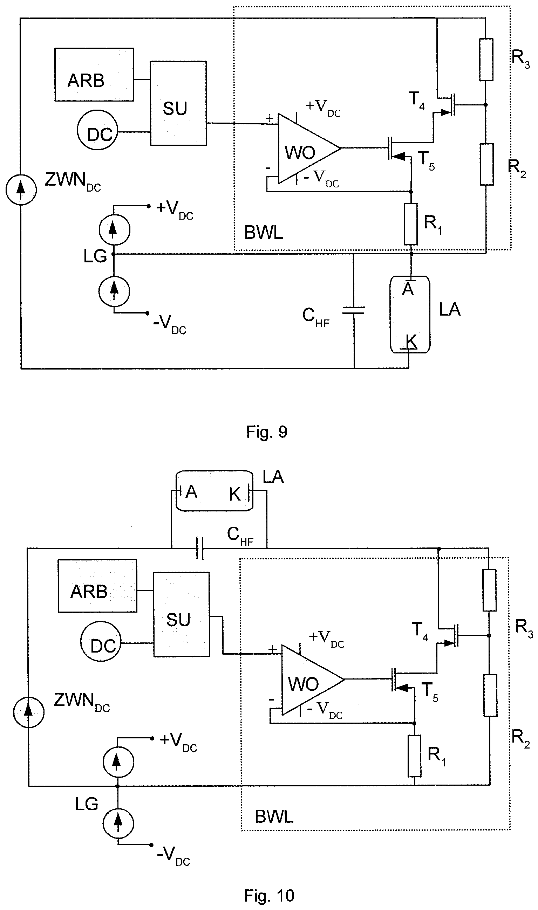

The subject of the invention is explained in the exemplary embodiments and shown in the drawing, in which:

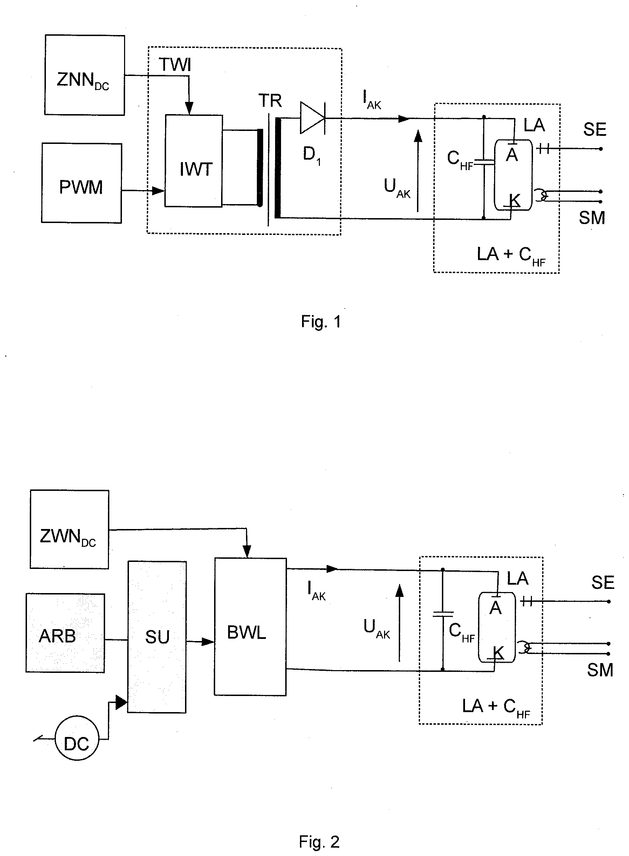

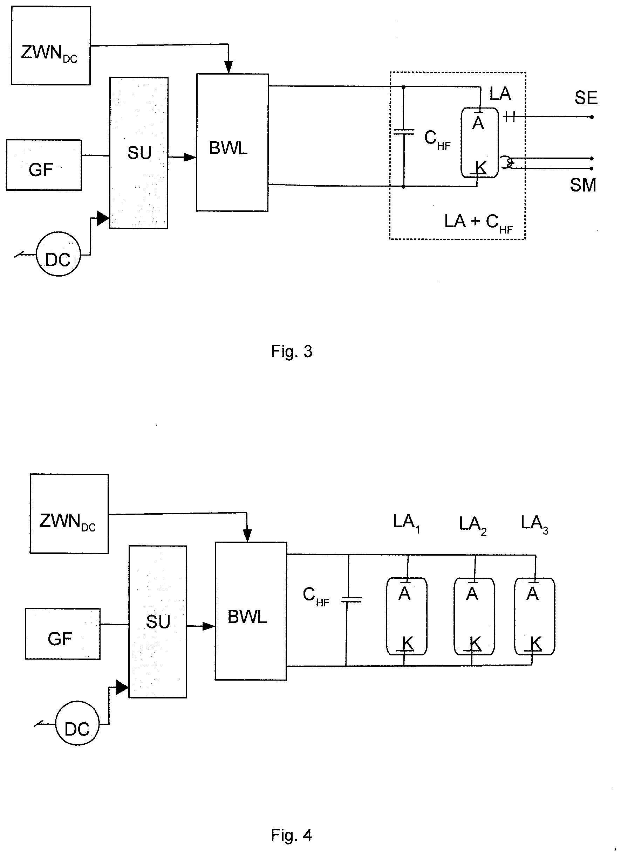

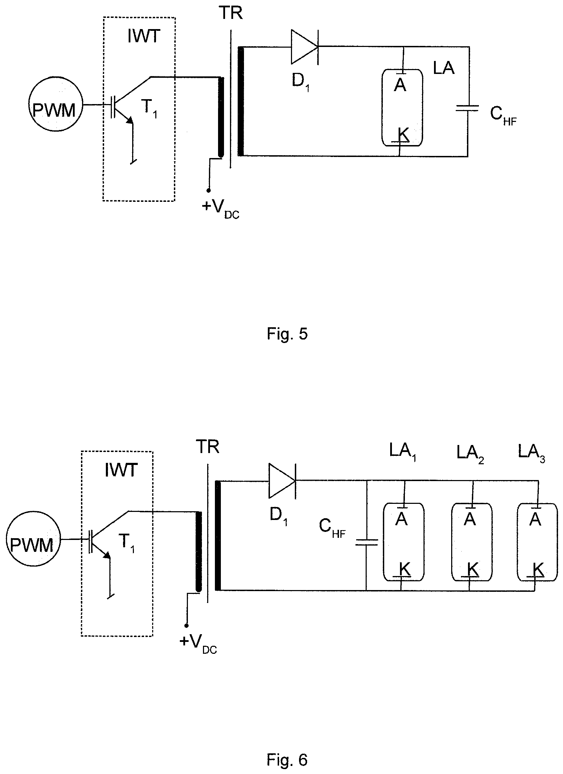

Fig. 1 shows a transformer system for generating electrode discharge pulses for generating a glow discharge in a chamber with reduced gas pressure equipped with a PWM (Power Width Modulation) waveform generator, Fig. 2 - a transformer-less pulse generator system supplying electrodes for generating a glow discharge in a chamber with reduced gas pressure equipped with an arbitrary waveform generator, Fig. 3 - transformer-less system for generating pulses supplying electrodes for generating glow discharge in a chamber with reduced gas pressure equipped with an arbitrary periodic waveform generator, Fig. 4- transformer-less system for generating impulses supplying electrodes for generating glow discharge in three chambers with reduced gas pressure equipped with an arbitrary waveform generator, Fig. 5 -transformer system with single-transistor pulse
amplifier - a transformer circuit with a single-transistor pulse amplifier for generating pulses supplying electrodes for generating a glow discharge in three discharge chambers, Fig. 7 - a transformer circuit with a two-transistor pulse amplifier, Fig. 8 - a transformer system with a pulse amplifier realized using an integrated bridge amplifier, Fig. 9 - a transformer-less system with a high voltage linear amplifier connected to the anode, Figure 10 - a transformer-less system with a high voltage linear amplifier connected to the cathode, Figure 11 -exemplary waveforms illustrating the pulse amplifier, Figure 12 - an example of arbitrary waveform.

### Example 1

The method of generating feed impulses for generating glow discharge between the electrodes enclosed in the chamber with reduced gas pressure consists in that with the use of a low power generator having in the form of a signal source with adjustable frequency and pulse width PWM pulses are generated and the pulse width W is selected, amplitude and repetition period of the T_{PWM} signal are selected, then their power and voltage of rectangular pulses are amplified in the TW1 transformer amplifier to the level necessary to ignite and maintain the glow discharge between the electrodes A, K maintaining the average current level I_{AK} and electrode supply voltage V_{AK} and the ratio the average voltage value U_{AV} over amplitude of the voltage pulses with adjustable frequency and width U_{(PWM)} is less than 2/π and equals 0.5, and the pulse repetition frequency is choose so that the quantity and intensity of resonance beats in plasma oscillations per unit of time monitored by the electric field sensor SE corresponds to the maximum power of coherent resonance oscillations. The glow discharge between the A and K electrodes is maintained at a working pressure of humid air of 1 Pa at a power density of 4 W / dcm³. The pulse repetition frequency is 125 Hz, the A_{DC} voltage amplitude level is selected such that the average current between the A, K electrodes is 100 µA.

### Example 2

The method of generating supply pulses to generate glow discharge between the electrodes enclosed in the chamber with reduced gas pressure proceeds as in the first example with the difference that using a low power generator in the form of an arbitrary ARB waveform generator pulses are generated as periodic arbitrary waveforms which are amplified in a transformer-less BWL linear amplifier. The glow discharge between electrodes A, K is maintained at a working air pressure of 104 Pa at a power density of 160 W / dcm³, the pulse repetition frequency is 14 kHz, and the amplitude level is selected so that the average current between the electrodes A , K is 2A, while the mean value of voltage U_{AV} is selected and corrected by means of DC voltage source. In addition, the ratio of the average voltage value U_{AV} to the voltage amplitude of the U_{ARB} arbitrary waveform is equal to 0.60.

### Example 3

The method of generating supply pulses for generating glow discharge between the electrodes enclosed in the chamber with reduced gas pressure is the same as in the second example, with the difference that using the low power generator in the form of an arbitrary periodic generator GF and a DC voltage source, sinusoidal pulses are generated with the amplitude of sinusoidal voltage Uₛᵢₙ.

### Example 4

The method of generating supply pulses for generating a glow discharge between the electrodes enclosed in the chamber with reduced gas pressure is the same as in the second example with the difference that using a low power generator in the form of an arbitrary periodic generator GF and a DC voltage source pulses are generated in the shape of absolute value of sinusoidal voltage |Uₛᵢₙ|.

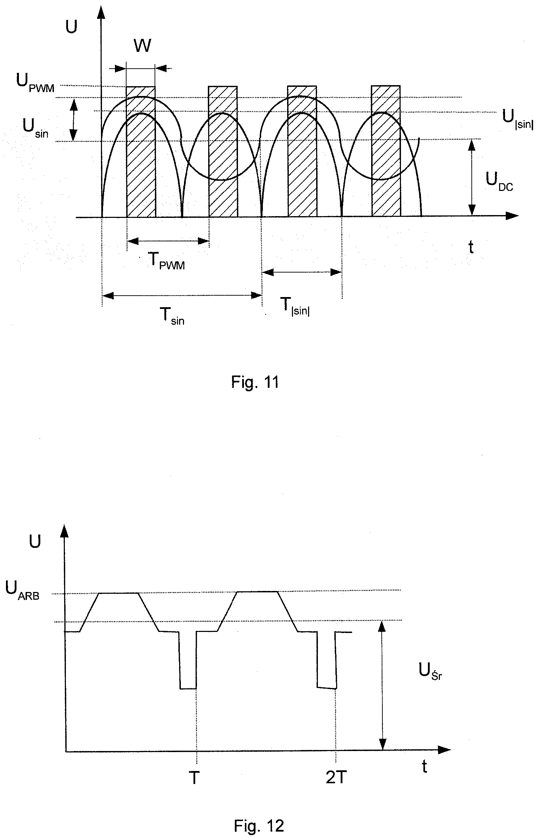

The method uses pulses of any shape (Fig. 11, Fig. 12), which are in particular selected from the group consisting of rectangular pulses with a pulse width W, voltage amplitude U_{PWM} with adjustable frequency and period T_{PWM} of signal repetition, sinusoidal pulses with Uₛᵢₙ voltage amplitude and Tₛᵢₙ sinusoidal period, sinusoidal pulses of the amplitude, absolute value U_{|sin|} and the period of the sinusoidal signal module T_{|sin|}, saw-tooth pulses and trapezoidal pulses. Such pulses can be obtained using simple generators of a dedicated functional course or with the use of arbitrary ARB waveform generators. In the method according to the invention, the glow discharge is fed by a constant DC voltage having both the alternating AC and a constant direct current DC component, wherein the AC voltage frequency, its shape and amplitude are selected, and the DC voltage level is selected so that the resultant average voltage between the electrodes is positive on the anode and negative on the cathode and cause electric current flowing through the plasma with the required non-zero average value, and at the same time that the ratio between the mean voltage between the electrodes and the maximum amplitude of this voltage is kept less than 2/π.

### Example 5

The system for generating supply pulses for generating a glow discharge between the electrodes enclosed in the chamber with reduced gas pressure has a high frequency CHF capacitor connected in parallel with the electrode anode A and cathode C terminals in the chamber LA and at the same time to the electrode terminals A, K the amplifier is connected driven from the source of control signals. The pulse amplifier is a transformer amplifier TWI which at the input has an pulse transistor IWT connected to the TR transformer primary winding, and the secondary transformer TR winding is connected through diode rectifier with diode D1 with electrode terminals A, K. The transistor pulse amplifier IWT is connected to the signal source with adjustable frequency and pulse width PWM and high voltage power source ZWN_{DC}. In addition, sensors for the SE field and magnetic field SM are located outside the chamber in the form of the LA lamp working at reduced gas pressure.

### Example 6

The system for generating power impulses to generate glow discharge between the electrodes enclosed in the chamber with reduced gas pressure made as in the fifth example with the difference that the pulse amplifier is a transformer less linear amplifier BWL and the source of control signals is an arbitrary ARB waveform generator connected by an adder SU to transformer-less linear amplifier BWL, where an adjustable DC voltage source is connected to the adder SU and the transformer-less linear amplifier BWL is connected to a high voltage ZWN_{DC} power source.

### Example 7

A system for generating supply pulses for generating glow discharge between electrodes enclosed in a chamber with reduced gas pressure made as in the sixth example with the difference that adder SU is connected to an arbitrary periodic waveform generator GF and to a regulated DC voltage source.

### Example 8

A system for generating supply pulses for generating glow discharge between the electrodes enclosed in a chamber with reduced gas pressure made as in the seventh example with the difference that to the transformer-less linear amplifier BWL three chambers in the form of first L₁, second L₂ and third L₃ lamps are connected in parallel.

### Example 9

The system for generating feed impulses for generating glow discharge between the electrodes enclosed in the chamber with reduced gas pressure made as in the fifth example with the difference that the transistor IWT is a transistor T₁. Transformer pulse amplifier TWI (Fig. 5) with transistor T₁ and booster transformer TR, whose secondary winding through the rectifier diode D₁, is connected to the electrodes A, K of the glow-arc lamp LA blocked by the C_{HF} capacitor. This system is powered from a +V_{DC} positive voltage source. The signal source with adjustable frequency and PWM pulse width is connected to the base of T₁ transistor of the IGBT type. Seeking the maximum resonant oscillation in the plasma monitored by the SE electric probe and / or magnetic SM, the frequency and width of the W pulse are selected from the PWM signal source with adjustable frequency and PWM pulse width, and last the amplitude of the amplifier boosting signal can be chosen agreeing for the reduced energy efficiency by the way of finding optimal conditions for plasma excitation in terms of the effectiveness of the process being carried out with its use.

### Example 10

A system for generating supply pulses for generating glow discharge between electrodes enclosed in a chamber with reduced gas pressure made as in the fifth example with the difference that to the transformer-less impulse amplifier BWL three chambers in the form of first L₁, second L₂ and third L₃ lamps connected in parallel.

### Example 11

A system for generating supply pulses to generate glow discharge between electrodes enclosed in a chamber with reduced gas pressure made as in the fifth example with the difference that the pulse transistor IWT at the input has a synchronous pulse generator DR equipped with a high level HS signal controller and a low level signal controller LS whereby the high level signal controller HS is connected to the gate of the upper transistor of the pulse amplifier T₂ the emitter of which is connected to the first terminal of the TR primary winding and simultaneously via the second energy return diode D₃ with the lower transistor amplifier T₃, and the signal controller the low LS level is connected to the gate of the lower transistor T₃ of the pulse amplifier the collector of which is connected to the second terminal of the transformer primary winding TR and at the same time through the first diode of the D₂ energy return with the collector of the upper transistor T₂ of the pulse amplifier, also the collector of the upper transistor T₂ of the pulse amplifier and the emitter of the lower transistor T₃ of the pulse amplifier are connected to the terminals of the DC voltage source.

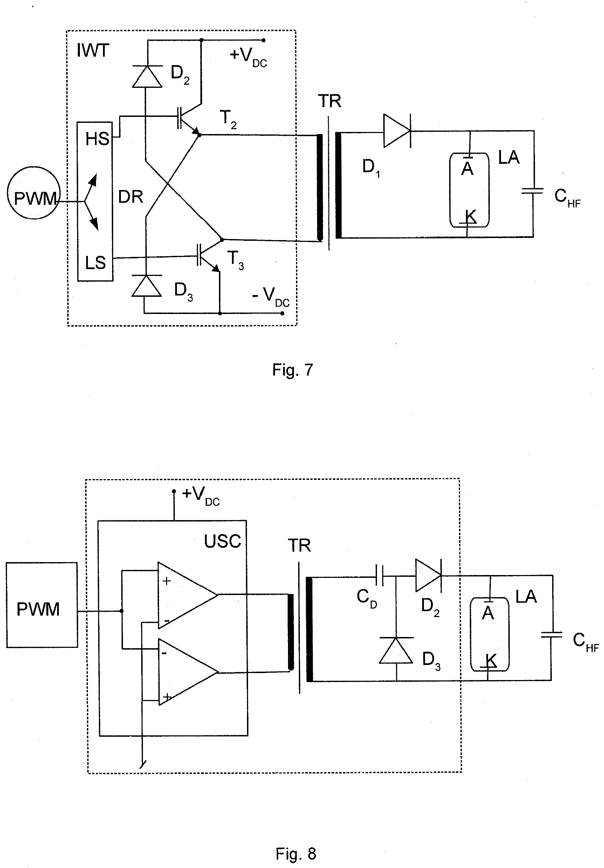

Transformer system with a two-cycle pulse amplifier (Fig. 7) with upper transistor amplifier T₂ and bottom transistor amplifier T₃ transistor and energy return diodes D₂ and D₂ connected respectively between the primary transformer TR and positive voltage +V_{DC} terminals and negative voltage sources -V_{DC}. The bases of the upper T₂ and lower T₃ amplifier transistors through the HS / LS driver system (High Side *I* Low Side driver) receive a PWM signal source separated from the signal source and addressed to the gates of both upper transistors T₂ and lower T₃ synch-phase pulses. On the secondary side of the TR transformer there is a rectifier with a rectifying diode D₁, which is then connected to the electrode terminals A, K of the lamp LA blocked with the C_{HF} capacitor.

### Example 12

The system for generating power impulses to generate glow discharge between the electrodes enclosed in the chamber with reduced gas pressure made as in the fifth example with the difference that the pulsed transistor amplifier IWT is the integrated circuit USC of the bridge amplifier, and the secondary transformer TR winding is connected with terminals A, K via a rectifier in the system voltage doubler with rectifier diodes D₁, D₄ and a capacitor CD with electrode terminals A, K.

A transformer system with a dual-transient pulse amplifier (Fig. 8) using the USC integrated circuit of the power bridge amplifier driven from the PWM generator and connected symmetrically to the primary winding of the TR transformer. The role of the rectifier is a voltage doubling system with a CD capacitor and energy return diodes - the first D₂ and the second D₃. The output of the rectifier is connected to the electrodes A, K of the fluorescent LA lamp blocked with the C_{HF} capacitor.

### Example 13

A system for generating supply pulses for generating glow discharge between electrodes enclosed in a chamber with reduced gas pressure made as in the sixth example with the difference that the transformer-less linear amplifier BWL is formed by high voltage transistors T₄, T₅, voltage divider R₃, R₂, resistor R₁ and operational amplifier WO the non-inverting input of which is connected to the adder SU while the inverting input is connected between the emitter of the lower transistor T₅ and the resistor of the current divider R₁, whereas the output of the operational amplifier WO is connected to the gate of transistor T₅, whose collector is connected to the emitter of transistor T₄ and the collector of the upper transistor T₄ is connected through the first resistor of the voltage divider R₂ and the second resistor R₃ with the second terminal of the current divider resistor R₁. In addition, the gate of upper transistor T₄ is connected between the first voltage divider resistor R₂ and the second voltage divider resistor in the R₃. In addition, the resistor of the current divider R1 and the first resistor of the voltage divider R₂ are connected to the anode A of the LA lamp. Moreover, the anode A of the LA lamp is connected to the local floating mass of the LG system located between the positive +V_{DC} and negative -V_{DC} sources.

Transformer-less system with high-voltage linear amplifier is connected to the electrodes A, K of the lamp LA locked with the CHF capacitor. A linear amplifier is constructed as a high voltage cross-over with upper transistor T₄ and lower transistor T₅. The upper transistor T₄ gate is supplied from a divider formed by a voltage divider first R₂ and second R₃ with the same value R₂= R₃ and the emitter of lower transistor T₅ is connected to the anode A of the lamp LA by the current sensing resistor R, sampling the current in the circuit of voltage controlled current source driven from the linear adder SU of the modulated signals, whose output is connected to the non-inverting input (+) of the operational amplifier WO. The possible waveforms given for the input of the SU add-on maz include sinusoidal waveform, absolute value of sinusoidal waveform, a constant voltage signal, frequency controlled signal, a pulse width W or any periodic waveform from an arbitrary waveform generator ARB created according to an individual project.

The system is powered by low voltage positive + Vc and negative -Vc sources, and by means of high voltage power source ZWN_{DC}. It should be noted that as in the case when the amplitude of the waveform generated by the PWM signal source can be adjusted at the input of transformer amplifier system also in the case of linear amplifier system agreeing with the energy efficiency of the amplifier there may be a problem of reduced efficiency combined with the need to discharge the lost heat. This may happen if the slope of the waveform chosen for control will not be sharp, Fortunately, the applications of glow plasma discussed here are characterized by relatively low levels of active power, almost never exceeding the level of several hundred watts.

### Example 14

An arrangement for generating supply pulses for generating a glow discharge between electrodes enclosed in a gas reduced chamber as in eleventh embodiment with the difference that the collector of upper transistor T₄ and the second voltage divider resistor R₃ are connected to the cathode K of the lamp LA. In addition, the anode A of the lamp LA is connected via a high voltage power source ZWN_{DC} to the local floating mass of the local grounding LG located between the positive +V_{DC} and negative -V_{DC} sources.

In the case when a step up transformer TR is used to obtain a high voltage (Fig. 1 ), a rectangular pulse amplifier WIP with adjustable frequency, i.e. an adjustable repetition period T and a regulated pulse width ti, is connected to the primary winding of this transformer. Such pulses are generated in generators representing a source of adjustable PWM frequency (Power Width Modulation). The amplified and transformed high voltage pulses that are obtained on the secondary side of the transformer are rectified by means of the rectifier with the second energy return diode DR, which is used to reproduce the high voltage constant component in proportion to the pulse width and the signal source with frequency and pulse width PWM, then the pulse voltage of high voltage pulses is fed without filtration to electrodes A, K of the plasma LA. In order to reduce the voltage noise associated with the rectangular shape and the sharp pulse slopes, a high frequency CHF capacitor is plugged in parallel between both A, K. This capacitor has such a low capacity that it essentially does not eliminate voltage ripples because they are indispensable in the process of stimulating plasma resonance oscillations. In this case, the value of the constant voltage component determines the ratio of the pulse width W to the repetition period T of the signal which is present in the variable frequency signal taken from the source of the PWM signal.

Dealing with more complex than that with adjustable frequency and PWM pulse width and introducing a constant current component becomes much simpler in cases without transformer (Figure 2) where a low voltage ZNN_{DC} power supply is used to feed a transformer-less linear amplifier BWL able to carry even very complicated electrical waveforms that are obtained in arbitrary waveform generators ARB.

In some cases an arbitrary ARB waveform generator can be substituted by an arbitrary periodic generator GF generating function waveforms, such as sine, sine absolute value or saw-tooth waveforms, respectively, compiled with a DC voltage source providing the required level of DC voltage supply A, K electrodes of the lamp LA. To monitor resonance oscillations in the plasma electric SE and magnetic SM probes located near the LA lamp are used connected to a digital oscilloscope.

List of markings in the drawing:
A - anode
ARB - an arbitrary waveform generator
BWL-transformer-less linear amplifier
CD - the compensator
C_{HF} - high frequency capacitor
D₁ -rectifier diode
D₂ - the first energy return diode
D₃ - the second energy return diode
D₄ - rectifier diode,
DC - DC voltage source
DR - synchronous pulse generation system
GF - generator of arbitrary periodic waveforms
IWT - transistor amplifier
K - cathode
LA-lamp
LG - local floating mass of the system
LS - low level signal controller
PWM - signal source with adjustable frequency and pulse width
R₁ - resistor of the power divider
R₂ - the first voltage divider resistor in the controller
R₃ - the second resistor of the voltage divider in the controller
SE - electric field sensor
SM- magnetic field sensor
ZS - a source of a sinusoidal signal
SU - adder
T₁ - transistor
T₂ - upper transistor of the impulse amplifier
T₃ - bottom transistor of the impulse amplifier,
T₄ - upper transistors transistor
T₅ - bottom transistors transistor
TR -transformer
TWI -transformer pulse amplifier
USC - Arrangement of bridge amplifier
WO - operational amplifier
ZNN_{DC} - power supply voltage
ZWN_{DC} - high voltage power supply
+V_{DC} - positive voltage source
-V_{DC} - the source of negative voltage
U_{DC} - DC voltage value
U_{AV} - average voltage value
U_{PWM} - voltage amplitude with adjustable frequency and pulse width
U_{ARB} - amplitude of the arbitrary wave voltage
Uₛᵢₙ - amplitude of sinusoidal voltage,
U_{|sin|} - amplitude of the absolute value sinusoidal voltage
T_{PWM} - signal repeatition period
Tₛᵢₙ - the period of a sinusoidal signal
T_{|sin|} - the period of the absolute value sinusoidal signal
W - pulse width

## Claims

1. A method for generating supply pulses for generating a glow discharge between electrodes enclosed in a chamber with reduced gas pressure, whereby a low power generator (PWM, ARB, DC, GF) generates pulses, and then increases their power and voltage to the level necessary to ignite and maintain the glow discharge between the electrodes (A, K), **characterized in that** their pulse shape, pulse magnitude, pulse repetition frequency and a level of DC voltage amplitude (U_{DC}) are selected so that the pulse repetition frequency is in the range of 125 Hz to a frequency below 15 kHz, and the pulse shape is selected from the group consisting of rectangular pulses, sinusoidal pulses, sinus module pulses, sawtooth pulses and trapezoidal pulses, and **in that** a ratio of the mean voltage value U_{w} to its amplitude (U_{PWM}, Uₛᵢₙ, Uₗₛᵢₙᵢ) is less than 2/π, wherein the glow discharge between the electrodes (A, K) is maintained at a working pressure of humid air in the range from 1 Pa to 10⁴ Pa at a power density in the discharge in the range from 0.2 to 200 W / dcm³, and the level of DC voltage amplitude (U_{DC}) is selected such that an average current between the electrodes (A, K) ranges from 100 µA to 2 A.

2. The method according to claim 1, **characterized in that** the pulse power is amplified in a transformerless linear amplifier (BWL), whereby the DC voltage is adjusted and/or corrected by means of an adjustable DC voltage source (DC).

3. A system for generating supply pulses for generating a glow discharge between electrodes enclosed in a chamber with reduced gas pressure, a high frequency capacitor (C_{HF}) is connected in parallel to terminals of at least one pair of electrodes constituting an anode (A) and a cathode (K), each pair of electrodes (A, K) is closed in the chamber (LA), and at the same time an impulse amplifier is connected to the electrodes terminals (A, K) **characterized in that** a pulse amplifier is a transformer pulse amplifier (TWI) that has a pulsed transistor amplifier (IWT) connected to an input transformer winding (TR) and a secondary transformer winding (TR) is connected via a diode rectifier (O₁) with the electrode terminals (A, K), wherein the pulse transistor amplifier (IWT) on the input has a synchronous pulse generator (DR) equipped with a high level signal controller (HS) and a low level signal controller (LS), a high level signal (HS) controller connected to each other with the gate of an upper transistor of an impulse amplifier (T₂), whose emitter is connected to the first terminal of the transformer primary winding (TR) and simultaneously via a second energy return diode (DJ) with an emitter of the lower transistor of an impulse amplifier (T₃), and the low level signal controller (LS) ) is connected to a gate of the lower transistor of the impulse amplifier (T₃), whose collector is connected to the second terminal of the transformer primary winding (TR) and simultaneously through a first energy return diode (D₂) with the collector of the upper transistor of the impulse amplifier (T₂), also the upper transistor collector pulse amplifier (T₂) and lower transistor emitter, and the pulse generator (T₃) is connected to t a regulated DC voltage source.

4. The system according to claim 3, **characterized in that** the transistor amplifier (IWT) is a transistor (T₁).

5. The system according to claim 3, wherein the transistor amplifier (IWT) is a bridge amplifier (USC) integrated circuit.

6. The system according to claim 3, **characterized in that** the secondary transformer winding (TR) is connected via a rectifier in a voltage doubler circuit with rectifier diodes (D₁, D4) and a capacitor (CD) with electrode terminals (A, K).

7. A system for generating supply pulses for generating a glow discharge between electrodes enclosed in a chamber with reduced gas pressure, a high frequency capacitor (C_{HF}) is connected in parallel to the terminals of at least one pair of electrodes constituting the anode (A) and cathode (K), each pair of electrodes (A, K) is closed in the chamber (LA), and at the same time an impulse amplifier is connected to the electrodes terminals (A, K) **characterized in that** the impulse amplifier is a transformer-less linear amplifier (BWL), wherein the transformer-less linear amplifier (BWL) is formed of a high voltage transistor (T₄, T₅), voltage divider (R₃, R₂) and current resistor (R₁) and operational amplifier (WO), the input not inverting the operation amplifier (WO) is connected to the adder (SU), the inverting op amps input (WO) is connected between the lower bearer transistor emitter (T₅) and the current divider resistor (R₁), and the operational silent output (WO) is connected to the lower transistor gate a wire (Ts) whose collector is connected to the emitter of the upper bearer transistor (T₄), and the upper transistor collector (T₄) is connected via the first voltage divider resistor in the controller (R₂) and the second voltage divider resistor in the controller (R₃) with the second the current divider resistor (R₁), in addition, the upper transistor barrier (T₄) is on after between the first voltage divider resistor in the controller (R₂) and the second voltage divider resistor in the controller (R₃).

8. The system according to claim 3, **characterized in that** the source of the control signals is a signal source with adjustable frequency and pulse width (PWM) and amplitude, which is connected to a pulsed transistor amplifier (TWT) powered by a low voltage power source (ZNNoc).

9. The system according to claim 3, **characterized in that** the source of control signals is an arbitrary waveform generator (ARB) connected by an adder (SU) to a transformer less linear amplifier (BWL), with an adjustable DC voltage source connected to the adder (SU), whereas a transformer-less amplifier is connected linear (BWL) is connected to a high voltage power source (ZWNDC).

10. The system according to claim 7, **characterized in that** for simplifying the arrangement, the arbitrary waveform generator (ARB) is replaced by an arbitrary periodic wavefonn generator (GF).

## Patentansprüche

1. Ein Verfahren zur Erzeugung von Versorgungsimpulsen zur Erzeugung einer Glimmentladung zwischen in einer Kammer mit reduziertem Gasdruck eingeschlossenen Elektroden, wobei ein Generator mit niedriger Leistung (PWM, ARB, DC, GF) Impulse erzeugt und dann deren Leistung und Spannung auf den Niveau erhöht, der notwendig ist, um die Glimmentladung zwischen den Elektroden (A, K) zu zünden und aufrechtzuerhalten, **dadurch gekennzeichnet, dass** deren Impulsform, Impulsgröße, Impulswiederholungsfrequenz und ein Niveau der Gleichspannungsamplitude (_{UDC}) so gewählt werden, dass die Impulswiederholungsfrequenz im Bereich von 125 Hz bis zu einer Frequenz unter 15 kHz liegt, und die Impulsform aus der Gruppe bestehend aus Rechteckimpulsen, Sinusimpulsen, Sinusmodulimpulsen, Sägezahnimpulsen und Trapezimpulsen ausgewählt ist, und dass ein Verhältnis des Spannungsmittelwertes U_{w} zu seiner Amplitude ((U_{PWM}, Uₛᵢₙ, Uₗₛᵢₙᵢ) kleiner als 2/π ist, wobei die Glimmentladung zwischen den Elektroden (A, K) bei einem Arbeitsdruck von feuchter Luft im Bereich von 1 Pa bis 10⁴ Pa bei einer Leistungsdichte in der Entladung im Bereich von 0.2 bis 200 W /dcm³ aufrechterhalten wird, und die Höhe der Gleichspannungsamplitude (U_{DC}) so gewählt wird, dass ein mittlerer Strom zwischen den Elektroden (A, K) im Bereich von 100 µA bis 2 A liegt.

2. Das Verfahren gemäß Anspruch 1, **dadurch gekennzeichnet, dass** die Impulsleistung in einem Linearverstärker (BWL) ohne Transformator verstärkt wird, wobei die Gleichspannung mit Hilfe einer einstellbaren Gleichspannungsquelle (DC) eingestellt und/oder korrigiert wird.

3. Ein System zur Erzeugung von Versorgungsimpulsen zur Erzeugung einer Glimmentladung zwischen Elektroden, die in einer Kammer mit reduziertem Gasdruck eingeschlossen sind, ein Hochfrequenzkondensator (C_{HF}) ist parallel mit den Anschlüssen von mindestens einem Paar von Elektroden angeschlossen, das eine Anode (A) und eine Kathode (K) bildet, wobei jedes Elektrodenpaar (A, K) in der Kammer (LA) eingeschlossen ist und gleichzeitig ein Impulsverstärker (TWI) mit den Elektrodenanschlüssen (A, K) verbunden ist, **dadurch gekennzeichnet, dass** ein Impulsverstärker ein Transformatorimpulsverstärker (TWI) ist, der mit einer Eingangstransformatorwicklung (TR) verbunden ist, und eine Sekundärtransformatorwicklung (TR) über einen Dioden-Gleichrichter (O₁) mit den Elektrodenanschlüssen (A, K) verbunden ist, **wobei** der Impulstransistorverstärker (IWT) eingangsseitig einen Synchronimpulsgenerator (DR) aufweist, der mit einem High-Level-Signalregler (HS) und einem Low-Level-Signalregler (LS) ausgestattet ist, wobei ein High-Level-Signalregler (HS) mit dem Gate eines oberen Transistors eines Impulsverstärkers (Tz) miteinander verbunden ist, wessen Emitter mit der ersten Klemme der Transformator-Primärwicklung (TR) und gleichzeitig über eine zweite Energierücklaufdiode (DJ) mit einem Emitter des unteren Transistors eines Impulsverstärkers (T₃), verbunden ist, und der Niederpegel-Signalregler (LS) mit einem Gate des unteren Transistors des Impulsverstärkers (T₃) verbunden ist, wessen Kollektor mit der zweiten Klemme der Transformator-Primärwicklung (TR) und gleichzeitig über eine erste Energierücklaufdiode (D₂) mit dem Kollektor des oberen Transistors des Impulsverstärkers (T₂), verbunden ist, auch der Kollektor des oberen Transistors des Impulsverstärkers (T₂) und der Emitter des unteren Transistors, und der Impulsgenerator (T₃) ist mit einer geregelten Gleichspannungsquelle verbunden.

4. Das System gemäß Anspruch 3, **dadurch gekennzeichnet, dass** der Transistorverstärker (IWT) ein Transistor (_{T1}) ist.

5. Das System gemäß Anspruch 3, wobei der Transistorverstärker (IWT) eine integrierte Brückenverstärkerschaltung (USC) ist.

6. Das System gemäß Anspruch 3, **dadurch gekennzeichnet, dass** die sekundäre Transformatorwicklung (TR) über einen Gleichrichter in einer Spannungsverdoppler-Schaltung mit Gleichrichterdioden (D₁, D4) und einem Kondensator (CD) mit Elektrodenanschlüssen (A, K) angeschlossen ist.

7. Ein System zum Erzeugen von Versorgungsimpulsen zur Erzeugung einer Glimmentladung zwischen Elektroden, die in einer Kammer mit reduziertem Gasdruck eingeschlossen sind, wobei ein Hochfrequenzkondensator (C_{HF}) parallel zu den Anschlüssen mindestens eines Paares von Elektroden, die die Anode (A) und die Kathode (K) bilden, geschaltet ist, jedes Paar von Elektroden (A, K) in der Kammer (LA) geschlossen ist und gleichzeitig ein Impulsverstärker mit den Elektrodenanschlüssen (A, K) verbunden ist, **dadurch gekennzeichnet, dass** der Impulsverstärker ein transformatorloser linearer Verstärker (BWL) ist, **wobei** der transformatorlose lineare Verstärker (BWL) aus einem Hochspannungstransistor (T₄, T₅), einem Spannungsteiler (R₃, R₂) und einem Stromwiderstand (R₁) und einem Operationsverstärker (WO) gebildet ist, wobei der nicht invertierende Eingang des Operationsverstärkers (WO) mit dem Addierer (SU) verbunden ist, der invertierende Operationsverstärkereingang (WO) zwischen den Emitter des unteren Trägertransistors (T₅) und den Stromteiler-Widerstand (R₁) geschaltet ist, und der stille Operationsverstärkerausgang (WO) mit dem unteren Transistor-Gate einen Draht (Ts) verbunden ist, dessen Kollektor mit dem Emitter des oberen Trägertransistors (R₃) verbunden ist und der obere Transistorkollektor (T₄) über den ersten Spannungsteiler-Widerstand im Controller (R₂) und den zweiten Spannungsteiler-Widerstand im Controller (R₃) mit dem zweiten Stromteiler-Widerstand (R₁) verbunden ist, außerdem ist die obere Transistor-Sperre (T₄) zwischen dem ersten Spannungsteiler-Widerstand im Controller (R₂) und dem zweiten Spannungsteiler-Widerstand im Controller (R₃) nachgeschaltet.

8. Das System gemäß Anspruch 3, **dadurch gekennzeichnet, dass** die Quelle der Steuersignale eine Signalquelle mit einstellbarer Frequenz und Pulsbreite (PWM) und Amplitude ist, die mit einem gepulsten Transistorverstärker (TWT) verbunden ist, der von einer Niederspannungsstromquelle (ZNNoc) gespeist wird.

9. Das System gemäß Anspruch 3, **dadurch gekennzeichnet, dass** die Quelle der Steuersignale ein Arbiträr-Wellenform-Generator (ARB) ist, der über einen Addierer (SU) mit einem transformatorlosen linearen Verstärker (BWL) verbunden ist, wobei eine einstellbare Gleichspannungsquelle mit dem Addierer (SU) verbunden ist, während ein transformatorloser linearer Verstärker (BWL) mit einer Hochspannungsstromquelle (ZWNDC) verbunden ist.

10. Das System gemäß Anspruch 7, **dadurch gekennzeichnet, dass** zur Vereinfachung der Anordnung des Arbiträr-Wellenform-Generators (ARB) durch einen Arbiträr-Funktionsgenerator (GF) ersetzt wird.

## Revendications

1. Méthode de génération d'impulsions d'alimentation pour générer une décharge lumineuse entre des électrodes enfermées dans une chambre à pression de gaz réduite, dans lequel un générateur de faible puissance (PWM, ARB, DC, GF) génère des impulsions, puis augmente leur puissance et leur tension jusqu'au niveau nécessaire pour allumer et maintenir la décharge lumineuse entre les électrodes (A, K), **caractérisé en ce que** leur forme d'impulsion, la magnitude de l'impulsion, la fréquence de répétition de l'impulsion et un niveau d'amplitude de tension continue (U_{DC}) sont sélectionnés de sorte que la fréquence de répétition de l'impulsion soit comprise entre 125 Hz et une fréquence inférieure à 15 kHz, et que la forme des impulsions soit choisie dans le groupe constitué par les impulsions rectangulaires, les impulsions sinusoïdales, les impulsions à module sinusoïdal, les impulsions en dents de scie et les impulsions trapézoïdales, et qu'un rapport entre la valeur moyenne de la tension U_{w} et son amplitude (U_{PWM}, Uₛᵢₙ, Uₗₛᵢₙᵢᵢ) soit inférieur à 2/π, la décharge luminescente entre les électrodes (A, K) étant maintenue à une pression de travail de l'air humide comprise entre 1 Pa et 10⁴ Pa et à une densité de puissance dans la décharge comprise entre 0.2 et 200 W / dcm³, et le niveau d'amplitude de la tension continue (U_{DC}) est sélectionnée de telle sorte qu'un courant moyen entre les électrodes (A, K) soit compris entre 100 µA et 2 A.

2. La méthode selon la revendication 1, **caractérisée par le fait que** la puissance d'impulsion est amplifiée dans un amplificateur linéaire sans transformateur (BWL), la tension continue étant ajustée et/ou corrigée au moyen d'une source de tension continue ajustable (DC).

3. Système de génération d'impulsions d'alimentation pour générer une décharge luminescente entre des électrodes enfermées dans une chambre à pression de gaz réduite, un condensateur haute fréquence (C_{HF}) est connecté en parallèle aux bornes d'au moins une paire d'électrodes constituant une anode (A) et une cathode (K), chaque paire d'électrodes (A, K) est fermée dans la chambre (LA), et en même temps un amplificateur d'impulsion est connecté aux bornes des électrodes (A, K) **caractérisé en ce qu'**un amplificateur d'impulsion est un amplificateur d'impulsion à transformateur (TWI) qui a un amplificateur à transistor pulsé (IWT) connecté à un enroulement de transformateur d'entrée (TR) et un enroulement de transformateur secondaire (TR) est connecté via un redresseur à diode (O₁) aux bornes des électrodes (A, K), dans lequel l'amplificateur d'impulsions à transistor (IWT) sur l'entrée a un générateur d'impulsion synchrone (DR) équipé d'un contrôleur de signal de haut niveau (HS) et d'un contrôleur de signal de bas niveau (LS), un contrôleur de signal de haut niveau (HS) connecté l'un à l'autre avec la grille d'un transistor supérieur d'un amplificateur d'impulsion (T₂), dont l'émetteur est connecté à la première borne de l'enroulement primaire du transformateur (TR) et simultanément via une seconde diode de retour d'énergie (DJ) avec un émetteur du transistor inférieur d'un amplificateur d'impulsion (T₃), et le contrôleur de signal de bas niveau (LS) est connecté à une grille du transistor inférieur de l'amplificateur d'impulsion (T₃), dont le collecteur est connecté à la deuxième borne de l'enroulement primaire du transformateur (TR) et simultanément à travers une première diode de retour d'énergie (D₂) avec le collecteur du transistor supérieur de l'amplificateur d'impulsion (T₂), également le collecteur du transistor supérieur de l'amplificateur d'impulsion (T₂) et l'émetteur du transistor inférieur, et le générateur d'impulsion (T₃) est connecté à une source de tension continue régulée.

4. Le système selon la revendication 3, **caractérisé par le fait que** l'amplificateur à transistor (IWT) est un transistor (T₁).

5. Le système selon la revendication 3, dans lequel l'amplificateur à transistors (IWT) est un circuit intégré d'amplificateur à pont (USC).

6. Le système selon la revendication 3, **caractérisé par le fait que** l'enroulement secondaire du transformateur (TR) est connecté via un redresseur dans un circuit doubleur de tension avec un redresseur à iodes (D₁, D4) et un condensateur (CD) avec des bornes d'électrodes (A, K).

7. Système de génération d'impulsions d'alimentation pour générer une décharge lumineuse entre des électrodes enfermées dans une chambre à pression de gaz réduite, un condensateur haute fréquence (C_{HF}) est connecté en parallèle aux bornes d'au moins une paire d'électrodes constituant l'anode (A) et la cathode (K), chaque paire d'électrodes (A, K) est fermée dans la chambre (LA), et en même temps un amplificateur d'impulsions est connecté aux bornes des électrodes (A, K), **caractérisé par le fait que** l'amplificateur d'impulsion est un amplificateur linéaire sans transformateur (BWL), dans lequel l'amplificateur linéaire sans transformateur (BWL) est formé d'un transistor haute tension (T₄, T₅), d'un diviseur de tension (R₃, R₂) et d'une résistance de courant (R₁) et d'un amplificateur opérationnel (WO), l'entrée n'inversant pas l'amplificateur opérationnel (WO) est connectée à l'additionneur (SU), l'entrée inverseuse de l'amplificateur opérationnel (WO) est connectée entre l'émetteur du transistor du porteur inférieur (T₅) et la résistance du diviseur de courant (R₁), et la sortie opérationnelle silencieuse (WO) est connectée à la grille du transistor inférieur un fil (Ts) dont le collecteur est connecté à l'émetteur du transistor du porteur supérieur (T₄), et le collecteur du transistor supérieur (T₄) est connecté via la première résistance de diviseur de tension dans le contrôleur (R₂) et la deuxième résistance de diviseur de tension dans le contrôleur (R₃) avec la deuxième résistance de diviseur de courant (R₁), en outre, la barrière du transistor supérieur (T₄) est activée après entre la première résistance de diviseur de tension dans le contrôleur (R₂) et la deuxième résistance de diviseur de tension dans le contrôleur (R₃).

8. Le système selon la revendication 3, **caractérisé par le fait que** la source des signaux de commande est une source de signaux dont la fréquence, la largeur d'impulsion (PWM) et l'amplitude sont réglables, qui est connecté à un amplificateur à transistors pulsés (TWT) alimenté par une source d'énergie à basse tension (ZNNoc).

9. Le système selon la revendication 3, **caractérisé par le fait que** la source des signaux de commande est un générateur de formes d'ondes arbitraires (ARB) connecté par un additionneur (SU) à un amplificateur linéaire sans transformateur (BWL), avec une source de tension continue réglable connectée à l'additionneur (SU), tandis que l'amplificateur linéaire sans transformateur (BWL) est connecté à une source d'alimentation à haute tension (ZWNDC).

10. Le système selon la revendication 7, **caractérisé par le fait que** pour simplifier l'arrangement, le générateur de formes d'onde arbitraires (ARB) est remplacé par un générateur de formes d'onde périodiques arbitraires (GF).
